# EUROPEAN PATENT APPLICATION

(11) **EP 4 266 842 A1**
(43) Date of publication of application: **25.10.2023**
(21) Application number: 22169516.6
(22) Date of filing: 22.04.2022
(51) Int. Cl.: H05K 3/38, H05K 1/02, H05K 1/18, H05K 3/00

(54) **PRINTED-CIRCUIT-BOARD STRUCTURE AND METHOD FOR MANUFACTURING**

(71) Applicant: Comet AG, 3175 Flamatt (CH)
(72) Inventor: GREDE, André, 3018 Bern (CH); GRUNER, Daniel, 79379 Müllheim (DE); LABANC, Anton, 79238 Ehrenkirchen (DE)
(74) Representative: dompatent von Kreisler Selting Werner - Partnerschaft von Patent- und Rechtsanwälten mbB

(57) **Abstract**

Printed-Circuit-Board structure (10), in particular for an RF generator, comprising: a heat spreader (14); a basic printed-circuit-board, PCB, (22) having an upper surface (18) and a lower surface (28), wherein the basic PCB (22) comprises a metallic layer (30) at the lower surface having at least one conductor line (24) and/or at least one contact pad (38); a contact layer (26), wherein the contact layer (26) comprises an upper surface directly connected to the metallic layer (30) of the basic PCB (22) and a lower surface (20); wherein the lower surface (20) of the contact layer (26) is bonded to the heat spreader (14) by a bonding layer (16).

## Description

### FIELD

The present invention relates to a Printed-Circuit-Board structure in particular for a radiofrequency (RF) generator, a method for manufacturing such a Printed-Circuit-Board structure as well as an RF generator comprising such a Printed-Circuit-Board structure.

### BACKGROUND

The RF power stage of an RF generator typically consists of a Power Amplifier and a Power Combiner Stage (if several Power Amplifiers are to be combined for higher output power). These circuits contain planar inductors and power transmission lines which can become hot in operation. As an example, RF generators rated to provide more than 1 kW high power signals typically contain power modules which may dissipate 20% or more of the rated power under certain conditions, for example in impedance-mismatched applications. Such RF generators for frequencies in the range 30 kHz to 300 MHz are frequently used in plasma power generation systems for semiconductor manufacturing, e. g. deposition and etch processes.

State-of-the art power amplifier designs employ planar structures which are integrated in the metal layers of a printed-circuit-board (PCB). The excessive heat produced by such planar inductor or power transmission line structures during RF power operation has to be removed by cooling the inductors or transmission lines appropriately. Typically, this is done by bonding the PCB onto heat spreaders.

Due to the different coefficients of thermal expansion (CTE) of the PCB and the heat spreader, the bond between these materials experiences stress when the temperature of the PCB heat spreader compound is changed.

During manufacturing, the highest temperature is applied during soldering of electronic components. For industrial oven soldering processes, the PCB is heated to temperatures between 200 and 250 °C. In regular operation in an RF generator, the described PCB heat spreader compounds can experience temperature cycles between room temperature and well above 100 °C. In both cases, soldering and thermal cycles in operation cause stress in the bond between the different materials of the PCB and the heat spreader which can cause delamination, i. e. separation of the PCB from the heat spreader and/or cracks in the bonding layer. Such structural deficiencies affect the efficiency of heat removal. In consequence, during operation, overheating and further damage to the circuit can occur.

In particular, the soldering problem can be solved by avoiding industrial processes which require heating the entire PCB heat spreader compound.

Instead of using oven soldering, the components can be manually soldered one by one using a solder iron. In this way, heat is only applied locally to the solder joint, and the thermal stress is minimized. However, manual soldering lacks the reproducibility of an automated process and, if improperly performed, can cause cold solder joints, damages to the components, or short circuits.

On the other hand, automated one-by-one soldering processes, e. g. automated iron soldering or laser soldering, which could be applied for selective soldering the individual components, are expensive and take longer time than standard industrial processes.

### PRIOR ART

EP2725880A1 describes the integration of a heat-generating component with a planar circuit board.

US6653741B2 describes the use of special materials, in particular a CTE modifying component, to reduce or prevent damage due to thermal cycling. The CTE modifying component is a special solder material and an additional material with an intermediate coefficient of thermal expansion between the two extreme values.

WO2020040725A1 describes a multi-stack cooling structure using various elements and arrangements like frames to achieve cooling of individual components. In particular, a heat spreader made of adjacent plates of copper and ceramic for cooling different parts of the circuit is described. In contrast to the present invention, the RF structures to be cooled in the referenced prior art are formed in the bottom metal of a PCB which is then bonded directly to the heat spreader. Such a structure can be further improved, especially with respect to cooling requirements and reliability requirements associated with demanding applications such as, for example, those of an RF generator. This will be further elucidated in the description that follows.

### SUMMARY

Thus, it is an object of the present invention to provide a PCB structure having an increased heat tolerance increasing the lifetime and reliability of the PCB heat spreader compound.

The problem is solved by a Printed-Circuit-Board structure according to claim 1, a method for manufacturing such a Printed-Circuit-Board structure according to claim 13 and an RF generator according to claim 16.

According to the present invention, a Printed-Circuit-Board structure, in particular for an RF generator, is provided. The Printed-Circuit-Board structure comprises a heat spreader having an upper surface and a lower surface. Further, the Printed-Circuit-Board structure comprises a basic Printed-Circuit-Board (PCB) having an upper surface and a lower surface. Therein, according to the present invention, the PCB comprises at least at its lower surface a metallic layer having at least one conductor line and/or at least one contact pad formed by the metal of the metallic layer. Preferably, by the metallic layer, a plurality of conductor lines and/or contact pads are formed. Further, the PCB structure comprises a contact layer, wherein the contact layer comprises an upper surface directly connected to the metallic layer and a lower surface. Therein, the lower surface of the contact layer is bonded to the heat spreader by a bonding layer which may be a liquid glue, prepreg, or a bonding film. Thereby, the lower surface of the contact layer is directly attached to the upper surface of the heat spreader by the bonding layer to form the Printed-Circuit-Board structure. Thus, by the contact layer, the lower surface of the basic PCB is covered, and the conductor lines and/or contact pads of the metallic layer are encapsulated

By adding an additional contact layer onto the metallic layer of the basic PCB, the metallic layer becomes an internal layer. Due to the nature of the material used to form the contact layer which becomes soft during the lamination process, the height differences in the structured metallic layer are leveled out by completely filling the gaps between individual metallic traces of the at least one conductor line and/or at least one contact pad. Thereby, a flat lower surface of the contact layer is provided. Thus, when bonding the basic PCB including the contact layer to the heat spreader by a bonding layer, homogenous bonding strength over the full surface is ensured, avoiding delamination and thermal cracks under heat of soldering or operation. Thus, the lifetime of the circuit can be increased. Further, in the process of laminating the contact layer to the basic PCB, which is typically realized by applying a pressure and/or elevated temperature, a homogeneous pressure can be applied to the contact layer such that a flat surface results. In this way a stable and reliable connection between the contact layer and the metallic layer is produced and bubbles/voids within the contact layer are avoided which would otherwise deteriorate heat dissipation towards the heat spreader. Due to separation of the steps of attaching the basic PCB to the heat spreader by adding first an additional contact layer and then bonding the basic PCB with the flat surface contact layer to the heat spreader, a much stronger bond is achieved compared to conventional technology, and delamination and cracks due to thermal effects can be reduced compared to the conventional situation in which the heat spreader is directly glued onto the metallic layer.

Preferably, the contact layer might be made of a prepreg or non-reinforced adhesive. Prepreg describes a composite material made from reinforced fibers which has been pre-impregnated with a resin system. Therein, the fibers of the prepreg can be arranged unidirectionally, as woven fabric or as unidirectionally arranged fibers in layers. Also, non-reinforced adhesives as sheets based on various resin systems can be used to form the contact layer. The contact layer is attached to the lower surface of the basic PCB in a lamination process during which pressure and heat are applied to the contact layer material. In the case of prepreg as contact layer material, the contact layer is cured and hardened in this process.

Preferably, the bonding layer is a prepreg or a non-reinforced adhesive sheet. Alternatively, a liquid glue system, e. g. epoxy, acryl or polyurethane may be used.

Preferably, the resulting contact layer may have a thickness ranging from 30 to 500 µm, preferably between 50 and 300 µm. Therein, by these measures on the one hand, a homogenous and flat surface is provided at the lower surface of the contact layer by filling the gaps between the respective conductor lines and/or contact pads of the basic PCB. On the other hand, sufficient heat transfer is still possible.

Preferably, the thickness of the contact layer is adapted to provide a planar or at least substantially planar lower surface with limited corrugation. As mentioned above, the thickness of the contact layer may be a tradeoff between requirements to provide a flat and homogenous surface at the lower surface of the contact layer and maintaining sufficient heat transfer from the basic PCB to the heat spreader. In particular, the thickness is adjusted in relation to the thickness of the (Cu) metal traces, i. e. the at least one conductor line and/or the at least one contact pad, of the metallic layer of the basic PCB, such that gaps between traces are completely filled and the corrugation of the surface of the cured contact layer is less than 30 µm, preferably less than 15 µm.

Preferably, the contact layer may be chosen approx. 30% - 200%, preferably 40% - 150%, and more preferably 50% - 100% thicker than the metallic layer of the basic PCB.

For example, for a Cu thickness of the metallic layer of 35 µm, the thickness of the contact layer can be chosen to be 60 µm, e. g. 1 layer of type 106 FR4 prepreg.

For Cu layers of 70 µm thickness of the metallic layer, the thickness of the contact layer may be 120 µm, e. g. two layers of type 106 FR4 prepreg.

For even thicker Cu layers of 105 µm of the metallic layer, the thickness of the contact layer may be 180 µm, e. g. three layers of type 106 FR4 prepreg or one layer of type 7628 FR4 prepreg.

If the operating temperature of the PCB structure in the application is above 100 °C, high-temperature materials and/or prepregs may be selected for the PCB structure as well as for the contact layer or the basic PCB.

For high-frequencies in the GHz range, instead of standard FR4 epoxy-resin based PCB materials filled with glass fibers, the material systems PTFE or polyimide with ceramic filling may be used.

Preferably, the bonding layer between the contact layer and the heat spreader, and the contact layer are two distinct layers. In particular, the contact layer is formed together in the process of manufacturing the basic PCB. Subsequently, the adhesive of the bonding layer is applied to the contact layer and/or the upper surface of the heat spreader in order to connect the contact layer with the heat spreader. Thus, the bonding layer and the contact layer are implemented in different steps of the process and aim for different functionality.

The basic PCB may be a one-layer, a two-layer or a multilayer structure. Depending on the complexity of the electronic circuit to be realized, the routing of the interconnects between the various electronic components may require a PCB with 3 or more metal layers, whereas simpler circuits can be realized with 2 or even 1 metal layer.

The PCB structure with the contact layer and the basic PCB according to the invention may be produced in standard PCB manufacturing processes using standard steps like drilling, plating, applying photoresist, etching, removing photoresist, oxidizing copper, laminating the prepreg and/or copper foils. For power electronic circuits according to the invention, ceramic or metal plates acting as heat spreaders may be added.

Preferably, the contact layer is added together with a metal (e. g. Cu) foil. In particular, the metal foil which is pressed onto the contact layer has a high roughness, preferably with Rz between 5 and 20 µm.

For circuits which only have a ceramic heat spreader, e. g. a power combiner or a hybrid combiner with only inductors or power lines to be cooled, the metal layer is completely etched away such that only the contact layer is left. In this way, the lower surface of the contact layer has obtained an imprinted roughness corresponding to the roughness of the metal foil which increases the surface area for bonding and facilitates the adhesion of the adhesive bonding layer to the heat spreader.

For circuits which require ground connections, e. g. a power amplifier which requires a combined ceramic and copper heat spreader, in the majority of the PCB area, the metal layer is etched away, but in some areas where a conductive connection to the metallic heat spreader is required, contact pads are protected by photoresist during the etching and remain at the lower surface of the contact layer. The copper foil acts in these areas as an additional contact metal layer at the lower surface of the contact layer. Also, in this variant, the contact layer surface inherits the roughness of the copper foil, and the adhesion of the bonding layer to the contact layer is improved.

In embodiments which require ground connections from the metallic layer to the heat spreader, additional process steps in the manufacturing sequence are required. In these embodiments, the contact layer and an additional metal foil are laminated in one step to the basic PCB. Then, the additional metal foil which is now the bottom metal layer is patterned with standard lithographic and etch processes such that metal pads are only left in those areas where electric contact to the heat spreader is required. The electric connection from other layers to these pads is made using vias. As a result, the majority of the lower surface of the basic PCB is covered with the bare, insulating contact layer, whereas in some defined areas, metallic pads provide an electrical connection to the heat spreader. When the basic PCB is laminated later to the heat spreader, the insulating bonding layer, e. g. epoxy prepreg or acrylic adhesive sheet, has cut-outs at the location of the contact pads. Into these cut-outs, appropriately sized pads of an electrically conductive bonding film are placed. When this combination of insulating and conductive adhesive layer is used to laminate the basic PCB to the heat spreader, the contact pads are electrically connected to the heat spreader via the electrically conductive bonding film, while all other parts of the circuit, in particular planar inductors and/or power transmission lines, which are encapsulated in the contact layer, are bonded to the heat spreader by an electrically insulating bonding layer.

Preferably, the heat spreader is made of a ceramic material and/or a metallic material. The metallic heat spreader is preferred to cool discrete components or planar components, in particular on the upper surface of the PCB, where the thickness of the basic PCB is sufficient to achieve the required inductance of planar inductor or impedance of transmission lines. For other planar components, for which higher inductance or impedance is required, in particular for planar structures in the metallic layer at the lower surface of the basic PCB, electrically non-conducting heat spreaders are used, because their volume can store alternating magnetic fields. Therefore, preferably, heat spreaders made of a ceramic with high thermal conductivity like alumina (Al₂O₃) or aluminum nitrate (AIN) are used. However, in particular if a connection to ground is required, in at least parts of the PCB structure, an electrically conductive heat spreader may be used, preferably made of copper or any other good thermal and electrical conductor. Thus, the heat spreader can be a ceramic substrate, a metallic substrate or a combination thereof.

The heat spreader may be mounted onto a heat sink. Therein, the heat sink may have integrated water cooling and/or may comprise radiators exposed to an airstream for cooling. The heat spreader and the heat sink may be integrally formed in some embodiments as a heat spreader compound. In other embodiments, heat spreader and heat sink are two parts connected to each other.

Preferably, the at least one conductor line is a power transmission line or a power planar inductor. In particular, by these types of conductor lines, a substantial amount of heat is generated which must be transferred to the heat spreader. At the same time, for these types of conductor lines, local overheating is possible. Therein, by using an additional contact layer, adhesion of the basic PCB to the heat spreader - in particular, in areas of increased heat by the powerline and/or the inductor - is improved and a reliable connection can be enabled, thereby improving also heat transfer to the heat spreader.

Preferably, one or more electronic components are placed onto the upper surface of the basic PCB and may be connected to the at least one conductor line and/or the at least one contact pad on the lower surface of the basic PCB by vias. Such connections to the metallic layer at the lower surface of the basic PCB and to the heat spreader allow an efficient heat removal from power components which are located on the upper surface. By using arrays of many vias, the thermal resistance of such connections from the upper surface of the PCB to the heat spreader and, therefore, to the heat sink can be reduced.

Before applying the contact layer to the metallic layer using standard PCB manufacturing processes, the metallic traces are also preferably treated with an inner-layer bonding coating, which may be a conversion coating like MultiBond^{™}, or an oxide, for achieving a high-reliability bond between the metal and the prepreg. This is advantageous compared to the previous method without a contact layer. In state-of-the-art methods, the open metal on both sides of a PCB is treated with a PCB surface finish (e. g. ENIG or similar) which is specifically targeted towards good solderability but not particularly for good bonding properties.

Preferably, the basic PCB may comprise at least one cut-out to mount an electronic component directly to the heat spreader. Therein, the cut-out may extend from the upper surface to the lower surface of the PCB and the contact layer directly revealing the heat spreader. Power components which require effective cooling in a direct manner can be directly attached to the heat spreader. Such power components could be power transistors (e. g. LDMOS, VDMOS, bipolar transistors) or power diodes producing larger amount of heat. As examples, diodes used for RF power amplifiers may generate heat of around several Watts, LDMOS transistors may generate heat of around 100 Watts or more, and typical power amplifier modules used in RF generators can generate hundreds of Watts or more. Components with less than 20 W heat generated may be assembled to the surface of the PCB, whereas components with heat generation of more than 50 W may preferably be directly attached to the heat spreader. However, the present invention is not limited to these components as power components directly attached to the heat spreader. Other components, e. g. power resistors, could also be mounted directly to the heat spreader inside of the cut-outs. The direct connection of such components to the heat spreader can be achieved, for example, by soldering, mechanical clamps, or screws. Depending on the type of direct connection, the components can be attached to the heat spreader before or after the basic PCB is bonded to the heat spreader.

Preferably, the basic PCB comprises at least one expansion slit. For large PCBs, for example exceeding a length of more than 10 cm or an area of more than 100 cm², the thermal stress due to the different coefficients of thermal expansion of the basic PCB and the heat spreader may exceed even the improved strength of the bond between basic PCB and heat spreader provided by the additional contact layer. In order to prevent delamination, the thermo-mechanical stress can be reduced by using expansion slits in the basic PCB. Such expansion slits can be realized by milling out small stripes of the basic PCB in suitable locations which preferably are distributed in several locations over the entire PCB area. Therein, the expansion slit may partially or completely form a gap between the upper surface and the lower surface of the basic PCB and may extend through the contact layer. Thus, by the expansion slit, the overall thermomechanical forces are reduced by breaking them into smaller areas, thus preventing cracks in the bonding layer and a delamination between the basic PCB and the heat spreader.

Preferably, more than one expansion slit is provided in the basic PCB and the contact layer, wherein in particular at least two expansion slits are arranged perpendicular to each other. Thus, by the perpendicular expansion slits, thermal expansion in two directions in the plane of the basic PCB can be reduced.

Preferably, the basic PCB is segmented into more than one segment by the expansion slits. Thus, the overall thermomechanical force can be reduced by splitting it into individual segments to acceptable values avoiding cracks or delamination.

Preferably, the segment size is less than 50cm², more preferably less than 30cm², and most preferably less than 15cm². However, exact numbers for the allowable size of the segments depend on the difference of the thermal expansion coefficient between the basic PCB and the heat spreader material, and the expected heat dissipated by each of the segments.

In another aspect of the present invention, a method for manufacturing a printed-circuit-board, PCB, structure is given including
- Providing a basic PCB having an upper surface and a lower surface, wherein a metallic layer at the lower surface comprises at least one conductor line and/or at least one contact pad;
- Laminating onto the metallic layer a contact layer having an upper surface directly connected to the metallic layer of the basic PCB and a lower surface;
- Bonding the lower surface of the contact layer to a heat spreader by a bonding layer to form the PCB structure.

In a first step, a basic PCB is provided having an upper surface and a lower surface. A metallic layer, e. g. made of copper, is provided at the lower surface. The metallic layer is structured to provide at least one conductor line and/or at least one conductor pad in the metallic layer. Preferably, by the metallic layer a plurality of conductor lines and/or contact pads are formed. Structuring the metallic layer can be done by any conventional process known in the art. Subsequently, a contact layer made preferably of reinforced adhesive, e. g. prepreg, or non-reinforced adhesive, is laminated onto the metallic layer. Thus, an upper surface of the contact layer is directly connected to the metallic layer of the basic PCB. Further, the contact layer has an opposite lower surface. During the pressing step of the lamination process, a homogenous pressure is applied to the basic PCB and the contact layer in order to ensure reliable connection between those layers. Preferably, the pressing step is performed under vacuum to avoid bubbles/voids in the contact layer or any other layer of basic PCB.

In an additional step, the lower surface of the contact layer is bonded to the heat spreader by a bonding layer, which also may involve a pressing process at elevated temperature. Thereby, the lower surface of the contact layer is bonded to the upper surface of the heat spreader, thereby connecting the basic PCB and the contact layer to the heat spreader.

The described method provides a PCB structure comprising a basic PCB, a contact layer, a bonding layer and a heat spreader, wherein the upper surface of the basic PCB can be populated with electronic components for soldering them advantageously in one step in an industrial oven process.

Preferably, the method is further built along with the features described in connection with the Printed-Circuit-Board configurations as described above.

Preferably, before bonding the contact layer to the heat spreader, cut-outs for electronic components are cut or milled into the basic PCB and preferably the contact layer.

Preferably, before bonding the contact layer to the heat spreader, at least one expansion slit is cut or milled into the PCB and preferably the contact layer. Therein, milling of the expansion slits can be done in the same step as cutting the cut-outs for the electronic components.

Preferably, after bonding the contact layer to the heat spreader, electrical components are soldered to the upper surface of the basic PCB and/or the heat spreader inside the cut-outs. During the solder step, high temperatures are applied to the PCB structure between usually 200 and 250°C in a reflow oven.

Thereby, due to the additional contact layer providing significantly higher peeling strength, delamination of the basic PCB and the heat spreader or cracks in the structure of the basic PCB are avoided.

In another aspect of the present invention, an RF generator for generating high power RF signals is provided comprising a PCB structure as described above.

### DESCRIPTION OF FIGURES

In the following, the present invention is described in more detail with reference to the accompanying figures.

The figures show:
Figure 1 a first embodiment of the PCB structure according to the present invention;
Figure 2A an example for a PCB structure according to the present invention populated with electronic components and in thermal contact with a heat sink;
Figure 2B a detailed view of the example of Fig. 2A;
Figure 3 a flow diagram of the method for manufacturing the PCB structure according to the present invention; and
Figure 4 a top view for an exemplified PCB structure according to the present invention.

### DETAILED DESCRIPTION

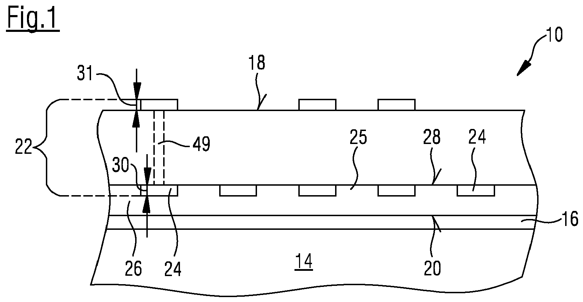

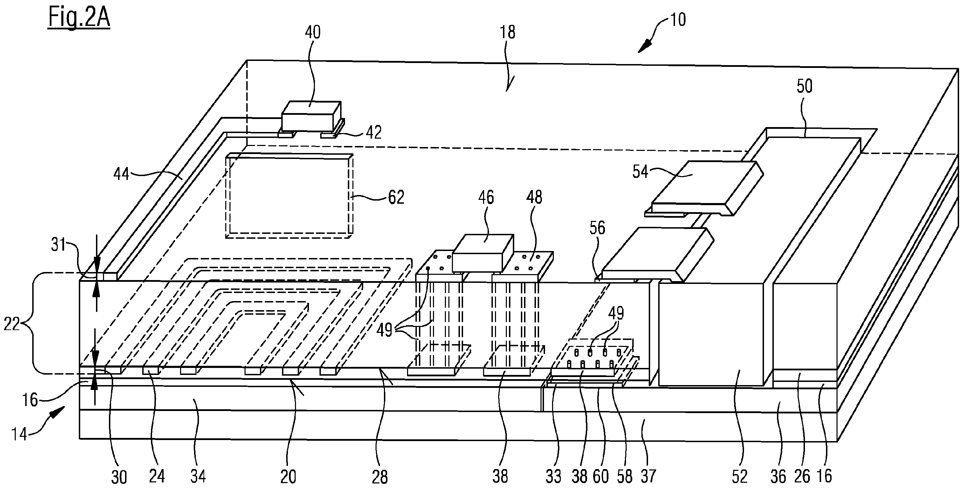

Referring to figure 1 showing a PCB structure 10, the PCB structure 10 comprises a basic PCB 22 a contact layer 26 bonded onto a heat spreader 14 via a bonding layer 16. Therein, the heat spreader 14 can be made of a non-conductive material such as a ceramic material or may be built of a conductive material such as copper. Also, a combination of different materials for one heat spreader 14 is possible. In Figure 1, the heat spreader 14 is shown as a simple substrate whereas Figure 2A shows a multiple-substrate heat spreader. The basic PCB 22 comprises an upper surface 18 and a lower surface 28. Therein, the contact layer 26 is laminated onto the lower surface 28 of the basic PCB 22 and bonded onto the heat spreader 14. Preferably, the upper surface of the heat spreader 14 is bonded with the lower surface 20 of the contact layer 26. At the lower surface 28 of the basic PCB 22, a metallic layer 30 is arranged. The metallic layer 30 may be made of copper. The metallic layer 30 may be structured into one or more conductor lines 24 as shown in Figure 1 and 2A and/or contact pads 38 as shown in Figure 2A. The conductor lines 24 are covered by the additional contact layer 26 made preferably of a reinforced adhesive, e. g. prepreg, or non-reinforced adhesive. By adding the additional layer of prepreg or non-reinforced adhesive onto the metallic layer 30, the metallic layer 30 becomes an internal layer. Due to the nature of the contact layer material which becomes soft during the lamination process, the height differences in the structured metallic layer 30 are leveled out by completely filling the gaps 25 between individual copper traces or conductor lines 24. The quantity of contact layer material must be sufficient to fully encapsulate the entire metallic layer 30, and by the compression during lamination, a flat lower surface 20 of the resulting contact layer is produced which has a limited corrugation, as explained previously, of less than 30µm, and preferably less than 15µm. Since usually the conductor lines 24 have a height of about 20µm to 100µm, and more preferably between 25µm und 40µm, the contact layer 26 may have a thickness of between 0.03mm and 0.5mm. More preferably, the contact layer 26 has a thickness of between 0.05mm and 0.3mm. Therein, by these measures, on the one hand, a homogenous and flat surface is provided at the lower surface 20 of the contact layer 26 by filling the gaps 25 between the respective conductor lines 24 and/or conductor pads 38. On the other hand, sufficient heat transfer is still possible.

The advantage of this additional contact layer 26 is that it provides a uniform and homogeneous surface to which the typical ceramic 34 or metallic 36 substrate (e.g. copper substrate) of the heat spreader 14 can be bonded by using a bonding layer 16. This bonding layer 16 can be a liquid glue, or, preferably, a reinforced or non-reinforced adhesive sheet.

In contrast, in the prior art, a basic PCB is bonded with an exposed bottom metallic layer to a heat spreader, i.e. a ceramic or copper substrate. This may result in unacceptably poor adhesion strength of a bonding layer. In particular, the incomplete filling of gaps between conductor lines and/or the surface finish of the exposed bottom metal can cause poor adhesion of the bonding layer which may result in delamination and other reliability issues, especially as a result of temperature changes during soldering and/or during operation of the high electric power devices implemented on the PCB assembly of the prior art.

Still referring to the prior art, the surfaces of the outer metal layers of a PCB are typically finished in an electro-chemical (e. g. a galvanic) process which adds additional metals like gold to prevent oxidation of the metallic layer, which is typically made of Cu. The adhesion of the glue to such treated metal surfaces depends on the surface finish process. The finish process is typically performed by PCB manufacturers which have to ensure that the resulting metal surface is compatible with soldering processes. However, the applicable surface specifications for soldering compatibility are not specifically targeted at providing a surface which has a particularly good adhesion

The above disadvantages of prior-art processes are overcome mainly by the additional contact layer 26 of the present invention. The same, established processes to treat the metallic layer 30 can be used as in regular PCB manufacturing of the inner layers of multi-layer boards such that an optimum adhesion of the contact layer material to the metal of the metallic layer and the bare surface of the basic PCB is obtained.

In consequence, delamination issues due to bond imperfections between basic PCB 22 and heat spreader 14 (or substrate 34, 36 of the heat spreader 14) are eliminated by adding the extra contact layer 26 to the metallic layer 30 at the lower surface of the basic PCB 22. In particular, due to the introduction of the additional contact layer 26, the risk of delamination of the basic PCB 22 from the heat spreader 14 (or substrate 34, 36 of the heat spreader 14) during the soldering of the electronic components to a top metal layer 31 is significantly reduced. The soldering of electronic components 40, 46 to the PCB structure 10 can be performed in regular industrial oven processes which heat up the entire PCB structure and solder all components in one step.

The use of the invention has the following benefits for the manufacturing and use of RF power circuits:
- Standard industrial (oven) soldering processes can be used to assemble electronic components onto the compound of basic PCB and heat spreader with significantly reduced risk of delamination between heat spreader and basic PCB.
- Longer lifetime of the bond in thermal cycling or regular power-cycling operation due to stronger bond.

Referring to Figure 2A, an example for a PCB structure 10 according to the present invention is provided which is populated with electronic components and which is in thermal contact with a heat sink 37. Therein, same or similar features are denoted by the same reference numbers.

The electronic circuit of Figure 2A shows another variant of a PCB structure 10 according to the invention, comprising a basic PCB 22. An additional contact layer 26 is connected to a lower surface 28 of the basic PCB 22. Further, the contact layer 26 is connected to a heat spreader 14 via a bonding layer 16.

The basic PCB 22 comprises a metallic layer 30, wherein the metallic layer 30 is structured to provide conductor lines 24, which can be a transmission line or a planar inductor. Alternatively or additionally, the metallic layer 30 may be structured to provide contact pads 38. The structures of the metallic layer 30 are encapsulated by the contact layer 26. By the contact layer 26, the height differences of the structures of the metallic layer 30 and the basic PCB surface without metal are leveled out in order to provide a flat and homogenous lower surface 20 of the contact layer 26. Thereby a good surface match between the lower surface 20 of the contact layer 26 and the upper surface of the heat spreader 14 is provided.

Therein, the heat spreader 14 may comprise a ceramic substrate 34 (ceramic heat spreader) which is electrically non-conductive in order to provide the space for the magnetic field between the conductor lines 24 of the metallic layer 30 and the heat spreader 14. In addition, the heat spreader 14 may comprise a metallic substrate 36 (metallic heat spreader), which may be connected to ground potential (not shown).

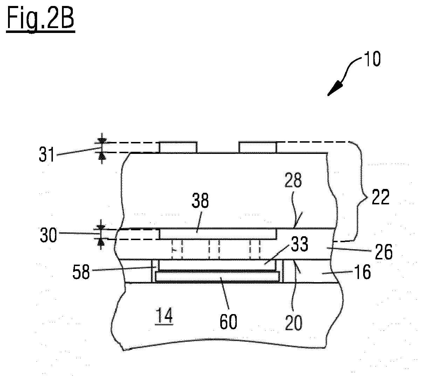

In the area of planar inductor structures 24 requiring additional space for the magnetic field (in the electrically non-conducting heat spreader 34), an electrically non-conducting bonding layer 16 is used. Referring to the Figure 2B, in the area of the metallic substrate 36 where a ground connection to the heatsink 37 via the metallic substrate 36 is necessary, an electrically conducting bonding layer 60 is used locally in defined areas, e. g. below conductor pads 38 of the metallic layer 30. Therein, the conductor pads 38 are connected to a contact metal layer 33 at the lower surface of the contact layer 26 by vias 49. In the area of the metallic substrate 36, where no electrical connection is necessary, an electrically non-conducting bonding layer 16 may be used.

On the upper surface 18 of the resulting PCB structure 10, electronic components 40, 46 can be attached to solder pads 42, 48 and electrically connected by conductor lines 44 arranged in a top metal layer 31 on the upper surface 18 of the PCB structure 10 or in inner metal layers (not shown) of the basic PCB 22. Therein, in particular for power components 46 such as power transistors (e. g. LDMOS, VDMOS, bipolar transistors), power diodes or power resistors, the solder pads 48 may be connected to contact pads 38 for grounding and/or cooling at the lower surface 28 of the basic PCB 22 by vias or arrays of vias 49, which are metal plated or filled with metal in order to provide an electrical and thermal connection to the contact pads 38.

The basic PCB 22 and preferably the contact layer 26 may comprise cut-outs 50, wherein in these cut-outs 50 power components 52, such as power transistors (e. g. LDMOS, VDMOS, bipolar transistors) can be directly mounted to the heat spreader 14. Therein, the power components 52 may be connected to the upper surface 18 of the basic PCB 22 via connecting elements 54 to solder pads 56 of the metallic layer 31 on the upper surface 18 of the PCB structure 10.

If there is a need to connect a contact pad 38 at the lower surface of the basic PCB 22 directly to the heat spreader 14, in particular in the area of the metallic substrate 36, the bonding layer 16 may comprise a cut-out 58 filled by an electrically conductive bonding film 60.

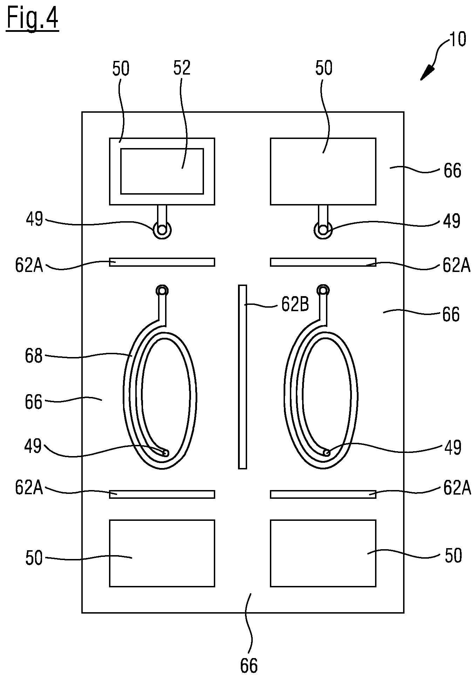

Further, the basic PCB 22 and preferably the contact layer 26 may comprise an expansion slit 62 in order to reduce thermomechanical forces between the basic PCB 22 and the bonding layer 16. Therein, it is referred to Figure 4 showing a schematic top view of a PCB structure 10 having heat producing metallic structures 68 and a plurality of expansion slits 62A and 62B. Therein, the expansion slits 62A, 62B are arranged perpendicular to each other in order to reduce thermomechanical forces in the two directions in the plane of the PCB structure 10.

By the thermal expansion slits 62A, 62B, the PCB structure 10 is segmented into different segments 66, thereby reducing the absolute value of the thermomechanical force during soldering and operation of the PCB 64. The width of the expansion slits may be in the range of 0.5mm to 5mm, more preferably between 0.5mm and 3mm, and most preferably between 1mm and 2mm. By the expansion slits 62A, 62B, the PCB structure 10 may be segmented into segments having an area of less than 50cm², more preferably less than 30cm², and most preferably less than 15cm². However, exact numbers for the allowable size of the segments depend on the PCB layout. The slits are preferably placed in areas without components and PCB tracks.

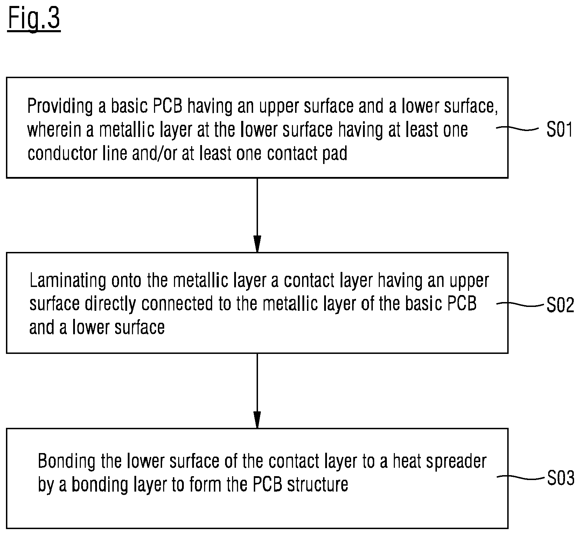

Referring to Figure 3, the method for manufacturing the PCB structure according to the present invention is shown.

In step S01, a basic PCB 22 is provided having an upper surface 18 and a lower surface, wherein a metallic layer 30 at the lower surface 28 having at least one conductor line (24) and/or at least one contact pad (38).

In step S02, a contact layer (26) is laminated onto the metallic layer having an upper surface directly connected to the metallic layer of the basic PCB (22) and a lower surface (20). By the contact layer 26, a flat and homogenous lower surface 20 is provided.

In step S03, the lower surface 20 of the contact layer 26 is bonded to a heat spreader 14 by a bonding layer 16 to form the PCB structure 10.

These process steps provide a PCB structure 10 to which electronic components 46, 40 may be soldered to contact pads 42, 48 on the upper surface 18 of the PCB structure 10. The soldering may be done in an industrial oven process, and preferably in one step. Due to the contact layer 26, the bond strength between the basic PCB 22 and the heat spreader 14 is improved and the risk of delamination during the oven process is reduced.

Before bonding the contact layer 26 to the heat spreader 14, one or more cut-outs 50 can be inserted into the basic PCB 22 and preferably the contact layer 26. In the same step or an additional step, one or more expansion slits 62 can be provided in the basic PCB 22 and preferably the contact layer 26.

Thus, by the present invention, a PCB structure 10 is provided having an additional contact layer 26 improving the bonding strength between the basic PCB 22 and the heat spreader 14. Thereby, delamination or cracks caused by the different thermal expansion coefficients of the basic PCB 22 and the heat spreader 14 can be significantly reduced. Further, the stress induced by the thermal expansion can be further reduced by inserting expansion slits 62 into the basic PCB 22 and preferably the contact layer 26.

### List of reference signs:

- 10:: PCB structure
- 14:: Heat spreader
- 16:: Bonding layer
- 18:: Upper surface of basic PCB
- 20:: Lower surface of the contact layer
- 22:: Basic PCB
- 24:: Conductor lines
- 25:: gaps between metal traces
- 26:: Contact layer
- 28:: Lower surface of the basic PCB
- 30:: Metallic layer
- 31:: Top metal layer
- 33:: Contact metal layer
- 34:: Ceramic substrate
- 36:: Metallic substrate
- 37:: Heat sink
- 38:: Contact pad
- 40:: Electronic component
- 42:: Solder pad
- 44:: Conductor line
- 46:: Power electronic component
- 48:: Solder pad
- 49:: Vias
- 50:: Cut-out
- 52:: Power electronic component
- 54:: Connecting element
- 56:: Solder pad
- 58:: Cut-out in bonding layer
- 60:: Electrically conducting bonding film
- 62, 62A, 62B:: Expansion slit
- 66:: PCB segment
- 68:: heat producing metallic structures

## Claims

1. Printed-Circuit-Board structure (10), in particular for an RF generator, comprising:
a heat spreader (14);
a basic printed-circuit-board, PCB, (22) having an upper surface (18) and a lower surface (28), wherein the basic PCB (22) comprises a metallic layer (30) at the lower surface having at least one conductor line (24) and/or at least one contact pad (38); and
a contact layer (26), wherein the contact layer (26) comprises an upper surface directly connected to the metallic layer (30) of the basic PCB (22) and a lower surface (20);
wherein the lower surface (20) of the contact layer (26) is bonded to the heat spreader (14) by a bonding layer (16).

2. Printed-Circuit-Board structure (10) according to claim 1, wherein the contact layer (26) is made of a prepreg or non-reinforced adhesive.

3. Printed-Circuit-Board structure (10) according to claims 1 or 2, wherein the bonding layer (16) comprises an adhesive based on a resin.

4. Printed-Circuit-Board structure (10) according to any of claims 1 to 3, wherein the bonding layer (16) comprises adhesive sheets.

5. Printed-Circuit-Board structure (10) according to any of claims 1 to 4, wherein the bonding layer (16) and the contact layer (26) of the PCB structure (10) are two distinct layers.

6. Printed-Circuit-Board structure (10) according to any of claims 1 to 5, wherein the contact layer (26) has a thickness of between 0.03 mm and 0.5 mm, and more preferably between 0.05 mm and 0.3 mm.

7. Printed-Circuit-Board structure (10) according to any of claims 1 to 6, wherein the thickness of the contact layer (26) is adapted to provide a planar lower surface (20).

8. Printed-Circuit-Board structure (10) according to any of claims 1 to 7, wherein the lower surface (20) of the contact layer (26) comprises a contact metal layer (33).

9. Printed-Circuit-Board structure (10) according to claim 8, wherein the bonding layer (16) has at least one cut-out (58) to accommodate a piece of electrically conductive bonding film (60) and provide an electrical connection between the contact metal layer (33) and the heat spreader (14).

10. Printed-Circuit-Board structure (10) according to any of claims 1 to 9, wherein the PCB comprises at least one expansion slit (62, 62A, 62B).

11. Printed-Circuit-Board structure (10) according to claim 10, comprising more than one expansion slit (62, 62A, 62B), wherein preferably at least two expansion slits (62A, 62B) are arranged perpendicular to each other.

12. Printed-Circuit-Board structure (10) according to claim 10 or 11, wherein the PCB structure (10) is segmented by the more than one expansion slit (62, 62A, 62B) and wherein preferably the size of the segments is less than 50cm², more preferably less than 30cm², and most preferably less than 15cm².

13. Method for manufacturing a printed-circuit-board, PCB, structure (10) including
Providing (S01) a basic PCB (22) having an upper surface (18) and a lower surface (28), wherein a metallic layer (30) at the lower surface (28) having at least one conductor line (24) and/or at least one contact pad (38);
Laminating (S02) onto the metallic layer (30) a contact layer (26) having an upper surface directly connected to the metallic layer of the basic PCB (22) and a lower surface (20);
Bonding (S03) the lower surface (20) of the contact layer (26) to a heat spreader (14) by a bonding layer (16) to form the PCB structure (10).

14. Method according to claim 13, wherein before bonding the basic PCB with the contact layer (26) to the heat spreader (14), milling at least one expansion slit (62, 62A, 62B) into the basic PCB (22) and preferably the contact layer (26).

15. Method according to claims 13 or 14, wherein the PCB structure is built according to any of claims 1 to 12.

16. RF-Generator for generating high power RF signals comprising a PCB structure according to any of claims 1 to 12 or a PCB structure built by the method according to any of claims 13 to 15.
